# EUROPEAN PATENT SPECIFICATION

(11) **EP 1 092 980 B1**
(45) Date of publication and mention of the grant of the patent: **02.11.2005**
(21) Application number: 00500196.1
(22) Date of filing: 05.09.2000
(51) Int. Cl.: G01R 15/26

(54) **Electrical current measurement transformers based on mechanical waves**
Elektrische Stromwandler basierend auf mechanischen Wellen
Tranformateurs pour mesurer le courant éléctrique basés sur ondes mécaniques

(30) Priority: 01.10.1999 ES 9902164
(43) Date of publication of application: 18.04.2001
(73) Proprietor: UNIVERSIDAD PONTIFICIA COMILLAS, E-28015 Madrid (ES)
(72) Inventor: Talavera Martin, Juan Antonio, 28230 Las Rozas de Madrid (ES)
(74) Representative: Riera Blanco, Juan Carlos

(56) References cited:
- EP-A- 0 701 139
- US-A- 5 612 495

## Description

### OBJECT OF THE INVENTION

This description refers to a Patented Invention for electrical current transformers based on mechanical waves, or, in other words, on the generation of elastic waves, whose purpose is to adapt, by means of different devices, the magnitude of the current of electrical circuits so that it can be measured, even though it may be a very high value, or circulate in high tension circuits. These devices consist of several force/magnetic field converters that generate, from the electro-magnetic fields, mechanical waves that propagate through various transmission structures to receivers where they are converted into electrical signals.

### FIELD OF THE INVENTION

These transformers are used to measure alternating current in electrical circuits whose current, or the required insulating strength are so high that they cannot directly enter the measurement device.

Although it may be used in a wide range of frequencies, the most important field of application is in installations for the generation, transport, and distribution of electrical energy, handling high voltages and currents at frequencies of 50 to 60 Hz.

It is also appropriate for use on all systems that require the measurement of high levels of current or that require galvanic separation between the primary circuit and the secondary or measurement circuit.

### BACKGROUND OF THE INVENTION

Current transformers are devices to modify the amplitude of electrical current.

Traditionally, this is achieved by the creation of a variable magnetic flow on the primary circuit that reaches the secondary circuit and induces variations in the electrical current that are opposed to the variations of magnetic flow. This phenomenon is explained well, in general, with Maxwell's equations.

The ratio of the number of loops of a primary and secondary circuit determines the ratio of the amplitudes of the primary and secondary currents. From the perspective of use as intermediate devices for the measurement of current, the possibility of modifying the amplitudes and adjusting them to the measurement equipment is useful, and the galvanic insulation that they provide when the primary and secondary circuits are connected with magnetic fields with no electrical contact between them, even more so.

This latter property makes them especially useful in large networks for the distribution of electrical energy where the voltages of the primary circuits are very high. Nevertheless, as the distribution output grows with a slow increase of the voltages and currents, not only do the dimensions of the primary circuit increase due to larger currents, but the galvanic insulation also increases. This makes the dimensions of the transformers, which reflect the product of both factors, grow to an extraordinary degree, becoming devices that are very large and disproportionately expensive for the power of the signals that they have to handle. This explains the interest in the development of new alternatives in this area in recent years.

Different devices have been proposed over the course of recent decades. However, the most important line of research is currently centred on the development of new systems based on fibre optics, both active and passive.

Given that optical fibres are made from nonconducting materials that are capable of transmitting energy in the form of light, but are not capable of transmitting electrons, these systems achieve a highly effective galvanic separation between the primary and secondary circuits.

Another equally effective alternative, in terms of the galvanic separation between the primary and secondary circuits, is based on the propagation of mechanical waves in dielectric media; the applicant holds the title to an Invention Patent file applied for in Spain with number 9401142/7 regarding electrical voltage measurement transformers. This application covers electrical current measurement transformers.

### DESCRIPTION OF THE INVENTION

In the electrical current measurement transformers based on mechanical waves that the invention proposes, the energy propagated by the dielectric material between the primary and secondary circuits is in the form of mechanical energy: elastic waves.

These transformers are made up of the following principal elements:
- Primary circuit conductor. The current that is to be measured circulates through this conductor.
- Magnetic field/force converter. Generates elastic waves from the alternating current circulating through the primary circuit. The current that circulates through the conductors induces magnetic fields around them. These magnetic fields are capable of producing force on a magnet, on a core of ferromagnetic material or on a coil with induced current. They may also change the dimensions of a magnetostrictive material. If the magnet, the ferromagnetic material, the coils, or the magnetostrictive material are mechanically coupled to a medium with a certain degree of stiffness, the alternating forces propagate through the material as elastic waves.
- Transmission structure. The transmission structure mechanically couples the magnetic field/force converter to the receiver. Therefore, the waves generated by the magnetic field/force converter propagate through a transmission structure made of a dielectric material to galvanically insulate the circuits and reach the receiver.
- Receiver. Built based on piezoelectric materials, it converts elastic waves into electrical signals. The magnitude of these electrical signals is related to the magnitude of the current circulating through the primary circuit. For magnetic field/force converters based on permanent magnets or magnetostrictive materials, the magnitude of the output signals of the receiver is approximately proportional to the current that circulates through the primary circuit, while for magnetic field/force converters based on ferromagnetic materials or coils, it is approximately proportional to the square of the magnitude of the current of the primary circuit.

As an option, an electrical unit is included to amplify the electrical signals coming from the receiver. This electrical unit also makes it possible to calibrate the system, compensate thermal drift, nonlinearity, phase difference between the original signal and the output signal, the aging of the characteristics of the materials, and to communicate with external acquisition systems.

### DESCRIPTION OF THE DRAWINGS

To complement the description, and in order to help provide a better understanding of the characteristics of this invention, this description is accompanied, as an integral part of it, by a set of diagrams, which are examples and not restrictive, that show the following:
Figure 1 shows the block diagram of the measurement transformers based on mechanical waves that are the object of the invention with the primary circuit, the magnetic field/force converter, the transmission structure, the receiver, and the amplifier.
Figure 2 shows the external side view of the first method of constructing a measurement transformer based on mechanical waves.
Figure 3 shows a side view in sections of the first method of constructing a measurement transformer based on mechanical waves.
Figure 4 shows the arrangement of the primary circuit and the magnetic field/force converter of the third method of constructing a measurement transformer based on mechanical waves.
Figure 5 shows the arrangement seen from above, in sections, of the primary circuit and the magnetic field/force converter of the third method of constructing a measurement transformer based on mechanical waves.
Figure 6 shows a side view, in sections, of the fifth method of constructing a measurement transformer based on mechanical waves.
Figure 7 shows a side view in sections of the receiver of the sixth method of constructing a measurement transformer based on mechanical waves.
Figure 8 shows a side view in sections of the seventh method of constructing a measurement transformer based on mechanical waves.

### PREFERRED EMBODIMENTS OF THE INVENTION

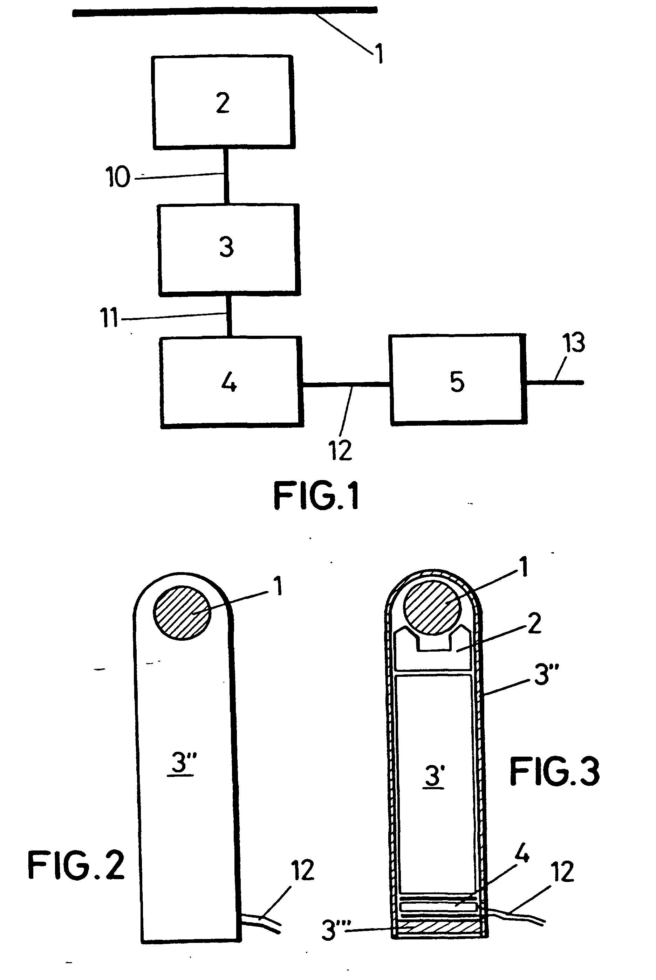

All of the embodiments have the block structure that is shown in figure 1. In this figure, the electrical current that circulates through the primary circuit (I) induces an alternating magnetic field that the magnetic field/force converter (2) converts into elastic waves (10) that propagate through the transmission structure (3) to the receiver (4). The receiver (4) converts these elastic waves (11) into electrical signals (12) that can be amplified by the electronic unit (5).

Figure 2 shows the external view of the first embodiment of the electrical current transformer. The conductor of the primary circuit is a rigid cylinder (1) that passes through the external shell of the transmission structure (3'). Through a hole in the lower part, two conductors extend that carry the electrical signals (12) coming from the receiver. This embodiment is based on a magnetic field/force converter based on a permanent magnet and transmission of the axial forces (traction/compression).

Figure 3 shows the interior of the previous embodiment of the electrical current transformer. The conductor of the primary circuit (1) generates a magnetic field that attracts and repels the magnet (2). This magnet (2) is rigidly coupled to the internal transmission structure (3') made of a rigid dielectric material. This cylindrical structure (3') is also rigidly connected to the receiver (4) made of a piezoelectric material, which allows it to transmit the mechanical stresses between the magnetic field/force converter (2) and the receiver (4). All of these components are installed inside an external shell (3"). In order for the receiver (4) to absorb the traction and compression forces, its lower end must be rigidly coupled to the lower part of the shell which is a screw (3"') that makes it possible to bring the magnetic field/force converter assembly (2), the internal structure (3'), and the receiver (4) closer, to a greater or lesser degree, to the conductor of the primary circuit (1). The two conductors (12) with the electrical output signals are connected to the electrodes of the receiver. The magnitudes of these electrical signals are proportional to the magnitudes of the currents that circulate through the primary circuit (1).

Changing the type of magnetic field/force converter produces new embodiments. A second embodiment that is proposed is to substitute the permanent magnet (2) with a core made of a ferromagnetic material. In this second method, the forces generated in the magnetic field/force converter are approximately proportional to the square of the current that circulates through the primary circuit.

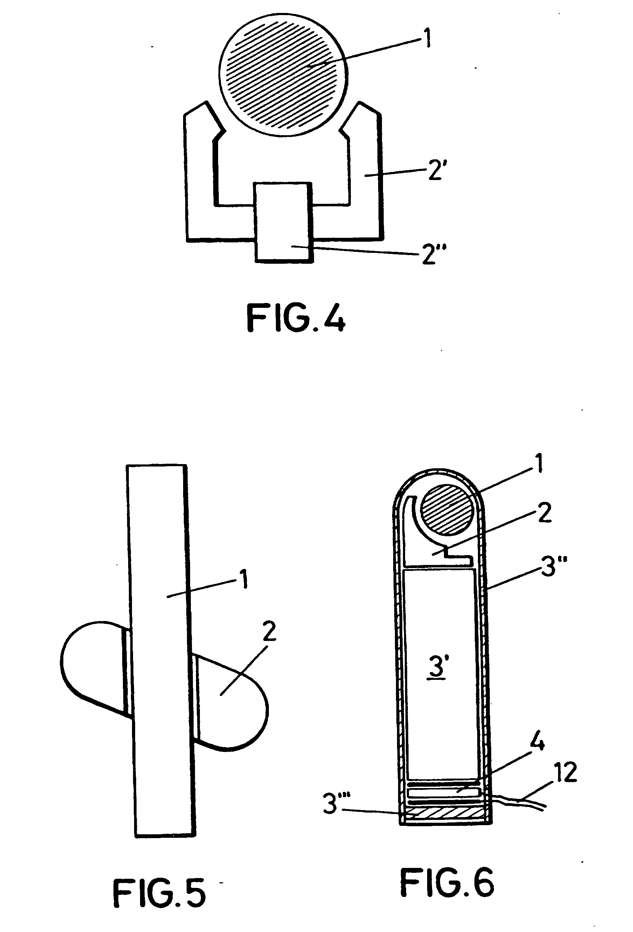

A third embodiment is shown in figure 4 and consists of substituting the magnet with a core (2') with coils (2") or short-circuited windings, in such a way that current is induced in them due to the variations in the magnetic field generated by the current in the primary circuit (1).

Other embodiments emerge due to the type of force transmitted. Figure 5 shows a fourth embodiment in which the magnetic field/force converter (2) transmits rotational force. Figure 5 shows a top view and schematic diagram of the current transformer in the fourth embodiment. The magnetic field generated by the current of the primary circuit (1), tends to turn the magnetic field/force converter (2).

Figure 6 shows a fifth embodiment where the transmitted forces are flexion. The magnetic field/force converter (2) moves toward or away from the conductor (1) of the primary circuit, making the internal transmission structure (3'), and consequently the receiver (4), flex.

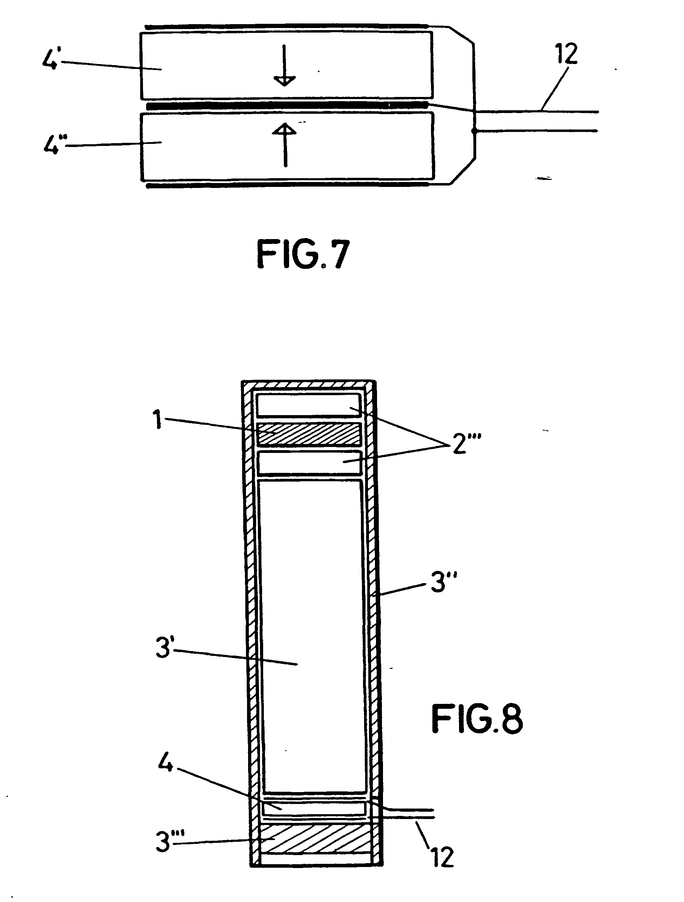

Different types of receivers produce other embodiments. A sixth embodiment is proposed in which the receiver is made up of several disks connected in parallel. The connection of disks made of a piezoelectric material in parallel reduces the output impedance and improves the ratio of the signal/electrical current transformer noise. Figure 7 shows a receiver made up of two disks (4' and 4") electrically connected in parallel but with an inverted spatial position as may be observed in the arrows indicating the polarisation.

Figure 8 shows a seventh embodiment in which the magnetic field/force converter (2) is made up of one or two pieces of a magnetostrictive material. The conductor of the primary circuit which in this method has a square or rectangular shape (1) is located between the two pieces of magnetostrictive material (2"'). The contractions and expansions of the magnetostrictive pieces propagate through the interior transmission structure (3'), reaching the receiver (4), which is made of piezoelectric material and which converts them into electrical signals (12). All of the components are introduced in the external shell of the transmission structure (3"). A screw (3"') in the lower part of the transmission structure serves to compress all of the internal components (1), (2), (3), and (4) in such a way that the expansion and compression of the magnetic field/force converter (2) are absorbed by the receiver (4). The internal transmission structure (3') galvanically separates the primary circuit (1) from the receiver (4).

It is not considered necessary to make this description more extensive for any person skilled in the art to understand the range of the invention and the advantages that it presents.

The materials, shape, and arrangement of the elements will be open to variation, provided that this does not involve an alteration in the essence of the invention.

The terms of this description must always be understood as broad and not restrictive.

## Claims

1. Electric current transformers based on mechanical waves, of the same type as those used for measuring the amplitude of the alternating current that flows around electric circuits, the general structure of which includes a conductor (1) of a primary circuit, a converter (2), which is in charge of generating elastic (mechanical) waves, a transmission structure (3, 3") made of a dielectric material which is in charge of transmitting the elastic waves, generated by the converter (4), a receiver (4) made of a piezoelectric material which receives the elastic waves and transforms them into electric waves, and an optional amplification unit (5) in charge of amplifying, where necessary, the electric signals coming from the receiver, wherein which said converter (2) is a converter of magnetic/force field in which the generation of elastic waves is carried out from the magnetic field generated by the current that flows around the primary circuit (1).

2. Electrical current measurement transformers based on mechanical waves, according to claim 1, **characterised by** being made up of a magnet (2) located very close to a cylindrical conductor of the primary circuit (1) and rigidly coupled to the internal transmission structure (3'), made of a dielectric material, which is rigidly connected to the receiver (4), which is also rigidly connected to the bottom part of the external shell of the transmission structure (3") that contains all of the elements.

3. Electrical current measurement transformers based on mechanical waves, according to claim 1, **characterised by** having a magnetic field/force converter (2) constructed based on a core of ferromagnetic material rigidly coupled to the internal transmission structure (3').

4. Electrical current measurement transformers based on mechanical waves, according to claim 1, **characterised by** having a magnetic field/force converter (2) formed by a coil or loop (2") that surrounds the magnetic core (2').

5. Electrical current measurement transformers based on mechanical waves, according to claim 1, **characterised by** having the axis of the magnetic field/force converter (2) tilted with respect to the axis of the primary circuit (1) and generating rotational force that propagates through the internal transmission structure (3') that rigidly connects the receiver (4) to the magnetic field/force converter (2).

6. Electrical current measurement transformers based on mechanical waves, according to claim 1, **characterised by** having a magnetic field/force converter (2) arranged laterally with respect to the conductor of the primary circuit (1) and generating flexion forces that propagate through the internal transmission structure (3') that rigidly connects the receiver (4) to the magnetic field/force converter (2).

7. Electrical current measurement transformers based on mechanical waves, according to claim 1, **characterised by** having a receiver (4) composed of two or more disks (4') and (4") made of piezoelectric material connected electrically in parallel and installed in pairs with the polarisation inverted.

8. Electrical current measurement transformers based on mechanical waves, according to claim 1, **characterised by** having a magnetic field/force converter (2) made up of one or two pieces of magnetostrictive material (2"') and (2"") surrounding the primary conductor (1).

## Patentansprüche

1. Elektrischer Strom-Messwandler, der auf mechanischen Wellen basiert, vom Typ derer, die zum Messen der Amplitude des um Stromkreise fliessenden Wechselstroms verwendet wird, dessen allgemeine Struktur einen Leiter (1) eines ersten Kreislaufes, einen Umformer (2), der für die Erzeugung elastischer (mechanischer) Wellen zuständig ist, eine aus einem dielektrischen Material hergestellte Übertragungsstruktur (3, 3"), die für die Übertragung der vom Umformer (4) erzeugten elastischen Wellen zuständig ist, einen aus einem piezoelektrischen Material hergestellten Empfänger (4), welcher die elastischen Wellen empfängt und in elektrische Wellen umwandelt, sowie wahlweise eine Verstärkereinheit (5), die dafür zuständig ist, falls notwendig die vom Empfänger stammenden elektrischen Signale zu verstärken, enthält, wobei der genannte Umformer (2) ein Magnet-/Kraftfeldumformer ist, bei welchem die Erzeugung elastischer Wellen von dem durch den um den ersten Kreislauf (1) fliessenden Strom erzeugten magnetischen Feld aus durchgeführt wird.

2. Elektrischer Strom-Messwandler, der auf mechanischen Wellen basiert, nach Anspruch 1, **dadurch gekennzeichnet, dass** er aus einem Magneten (2) hergestellt ist, der sehr nahe an dem zylinderförmigen Stromleiter des ersten Kreislaufes (1) angebracht ist und fest mit der inneren Übertragungsstruktur (3') verbunden ist, die aus einem dielektrischen Material hergestellt ist und die fest mit dem Empfänger (4) verbunden ist, der wiederum fest mit dem Unterteil des äußeren Gehäuses der Übertragungsstruktur (3") verbunden ist, die alle Elemente beinhaltet.

3. Elektrischer Strom-Messwandler, der auf mechanischen Wellen basiert, nach Anspruch 1, **dadurch gekennzeichnet, dass** er einen magnetischen Feld/Kraft-Umformer (2) besitzt, der auf der Basis eines Ferromagnetikum-Kerns konstruiert ist, der fest mit der inneren Übertragungsstruktur (3') verbunden ist.

4. Elektrischer Strom-Messwandler, der auf mechanischen Wellen basiert, nach Anspruch 1, **dadurch gekennzeichnet, dass** er einen magnetischen Feld/Kraft-Umformer (2) besitzt, der aus einer Spule oder einem Ring (2") gebildet ist, die/der den magnetischen Kern (2') umschließt.

5. Elektrischer Strom-Messwandler, der auf mechanischen Wellen basiert, nach Anspruch 1, **dadurch gekennzeichnet, dass** die Achse des magnetischen Feld/Kraft-Umformer (2) hinsichtlich der Achse des ersten Kreislaufes (1) geneigt ist und dadurch, dass er eine Rotationskraft erzeugt, die sich über die innere Übertragunsstruktur (3') ausbreitet, die den Empfänger (4) fest mit dem magnetischen Feld/Kraft-Umformer (2) verbindet.

6. Elektrischer Strom-Messwandler, der auf mechanischen Wellen basiert, nach Anspruch 1, **dadurch gekennzeichnet, dass** er einen magnetischen Feld/Kraft-Umformer (2) besitzt, der hinsichtlich des Stromleiters des ersten Kreislaufes (1) seitlich angebracht ist und dadurch, dass er Flexionskräfte erzeugt, die sich über die innere Übertragunsstruktur (3') ausbreiten, die den Empfänger (4) fest mit dem magnetischen Feld/Kraft-Umformer (2) verbindet.

7. Elektrischer Strom-Messwandler, der auf mechanischen Wellen basiert, nach Anspruch 1, **dadurch gekennzeichnet, dass** er einen Empfänger (4) besitzt, der aus zwei Scheiben (4') und (4") zusammengesetzt ist, die aus piezoelektrischem Material hergestellt sind, das in Parallelschaltung elektrisch verbunden ist und in Paaren mit umgekehrten Polarisation installiert ist.

8. Elektrischer Strom-Messwandler, der auf mechanischen Wellen basiert, nach Anspruch 1, **dadurch gekennzeichnet, dass** er einen magnetischen Feld/Kraft-Umformer (2) besitzt, der aus einem oder zwei Teilen aus magnetostriktivem Material (2"') und (2"") hergestellt ist, das/die den ersten Stromleiter (1) umschließt/en.

## Revendications

1. Transformateurs de courant électrique basés sur des ondes mécaniques, du même type que ceux utilisés pour mesurer l'ampleur du courant alternatif qui se propage autour de circuits électriques, dont la structure générale inclut un conducteur (1) d'un circuit primaire, un convertisseur (2), destiné à générer des ondes élastiques (mécaniques), une structure de transmission (3, 3") fabriquée à partir d'un matériau diélectrique destinée à transmettre les ondes élastiques, générées par le convertisseur (4), un récepteur (4) fabriqué à partir d'un matériau piézoélectrique qui reçoit les ondes élastiques et les transforme en ondes électriques, et une unité d'amplification optionuelle (5) destinée à amplifier, si besoin est, les signaux électriques provenant du récepteur, dans lequel ledit convertisseur (2) est un convertisseur de champ/force magnétique dans lequel la génération d'ondes élastiques s'effectue depuis le champ magnétique généré par le courant qui se propage autour du circuit primaire (1).

2. Transformateurs de mesure de courant électrique basés sur des ondes mécaniques, selon la revendication 1, **caractérisés en ce que** qu'ils sont composés d'un aimant (2) se trouvant tout près du conducteur cylindrique du circuit primaire (1) et monté de manière rigide sur la structure de transmission interne (3'), fabriqué avec un matériau diélectrique relié de manière rigide au récepteur (4), lequel est également relié de manière rigide à la partie du bas du boîtier externe de la structure de transmission (3") contenant tous les éléments.

3. Transformateurs de mesure de courant électrique basés sur des ondes mécaniques, selon la revendication 1, **caractérisés en ce que** qu'ils possèdent un convertisseur de champ/force magnétique (2) fabriqué à partir du noyau d'un matériau ferromagnétique monté de manière rigide sur la structure de transmission interne (3').

4. Transformateurs de mesure de courant électrique basés sur des ondes mécaniques, selon la revendication 1, **caractérisés en ce que** qu'ils possèdent un convertisseur de champ/force magnétique (2) formé d'une boucle ou bobine (2") qui entoure le noyau magnétique (2').

5. Transformateurs de mesure de courant électrique basés sur des ondes mécaniques, selon la revendication 1, **caractérisés en ce que** l'axe du convertisseur de champ/force magnétique (2) est incliné par rapport à l'axe du circuit primaire (1) et qu'il produit une force de rotation qui se propage à travers la structure de transmission interne (3') qui relie de manière rigide le récepteur (4) au convertisseur de champ/force magnétique (2).

6. Transformateurs de mesure de courant électrique basés sur des ondes mécaniques, selon la revendication 1, **caractérisés en ce que** leur convertisseur de champ/force magnétique (2) est placé latéralement par rapport au conducteur du circuit primaire (1) et qu'il produit des forces de flexion qui se propagent à travers la structure de transmission interne (3') qui relie de manière rigide le récepteur (4) au convertisseur de champ/force magnétique (2).

7. Transformateurs de mesure de courant électrique basés sur des ondes mécaniques, selon la revendication 1, **caractérisés en ce qu'**ils possèdent un récepteur (4) composé de deux, ou davantage, disques (4') et (4") fabriqués en matériau piézoélectrique relié électriquement en parallèle et monté en paires en polarisation inversée.

8. Transformateurs de mesure de courant électrique basés sur des ondes mécaniques, selon la revendication 1, **caractérisés en ce que** leur convertisseur de champ/force magnétique (2) est composé d'une ou de deux pièces de matériau magnétostrictif (2"') et (2"") qui entourent le conducteur primaire (1).
